# EUROPÄISCHE PATENTSCHRIFT

(11) **EP 3 023 226 B1**
(45) Veröffentlichungstag und Bekanntmachung des Hinweises auf die Patenterteilung: **08.02.2017**
(21) Anmeldenummer: 14193953.8
(22) Anmeldetag: 19.11.2014
(51) Int. Cl.: B29C 67/00

(54) **Stereolithographievorrichtung mit Heizeinrichtung**
Stereolithography device with a heating device
Dispositif de stéréo-lithographie et dispositif de chauffage

(43) Veröffentlichungstag der Anmeldung: 25.05.2016
(73) Patentinhaber: Ivoclar Vivadent AG, 9494 Schaan (LI); Technische Universität Wien, 1040 Wien (AT)
(72) Erfinder: Ebert, Jörg, 9470 Buchs (CH); Gmeiner, Robert, 1040 Wien (AT)
(74) Vertreter: Uexküll & Stolberg

(56) Entgegenhaltungen:
- US-A- 5 545 367

## Beschreibung

Die vorliegende Erfindung betrifft eine Stereolithographievorrichtung mit einer Wanne zur Aufnahme von fließfähigem, photopolymerisierbarem Material, die wenigstens in einem für Belichtungen vorgesehenen Belichtungsgebiet einen transparenten Wannenboden aufweist, einer unter der Wanne angeordneten Belichtungseinheit zur Belichtung einer Fläche mit einer für die jeweils zu bildende Schicht vorgegebenen Kontur innerhalb des Belichtungsgebiets, einer über dem Wannenboden an einer Hebeeinrichtung aufgehängten Bauplattform, an der anhängend die erste durch Belichtung ausgehärtete Schicht zu bilden ist, einer Steuereinheit, die dazu eingerichtet ist, sukzessive Belichtungen mit jeweils vorgegebener Kontur durch die Belichtungseinheit zu bewirken und die Stellung der Bauplattform über dem Wannenboden sukzessive jeweils nach dem Belichten einer weiteren Schicht anzupassen, und mit einer Heizeinrichtung zur Erwärmung des photopolymerisierbaren Materials in der Wanne.

Eine Stereolithographievorrichtung ist z.B. aus WO 2010/045950 A1 bekannt, die sich insbesondere auf den Aufbau von Dentalrestaurationen aus flüssigen, photopolymerisierbaren Materialien bezieht. Bei der bekannten Stereolithographievorrichtung wird eine Bauplattform vertikal beweglich über einem Wannenboden gehalten, der lichtdurchlässig ausgebildet ist. Unterhalb des Wannenbodens befindet sich eine Belichtungseinheit. Die Bauplattform wird zunächst in die Wanne, in die fließfähiges, photopolymerisierbares Material gefüllt ist, soweit abgesenkt, bis zwischen der Bauplattform und dem Wannenboden nur noch eine Schicht mit der gewünschten Schichtdicke aus photopolymerisierbarem Material verbleibt. Anschließend wird diese Schicht mit einer vorgegebenen Kontur in einem Belichtungsgebiet durch die Belichtungseinheit belichtet und dadurch ausgehärtet. Nach Anheben der Bauplattform wird photopolymerisierbares Material in das Belichtungsgebiet unter der Bauplattform nachgeführt, was durch irgendeine Art von Verteilungsvorrichtung geschehen kann, z.B. durch eine Rakel, die in definiertem Abstand über den Wannenboden relativ zu diesem bewegt wird, um photopolymerisierbares Material in das Belichtungsgebiet zu schieben und dort glatt zu streichen. Die anschließende Definition der Schichtdicke erfolgt wie beschrieben durch Absenken der Bauplattform in das nachgeführte photopolymerisierbare Material, wobei überschüssiges photopolymerisierbares Material aus dem Zwischenraum zwischen der Unterseite der zuletzt gebildeten Schicht in dem Wannenboden verdrängt wird. Bei dieser generativen schichtweisen Fertigung des Formkörpers werden sukzessive Schichten mit jeweils vorgegebener Kontur, die in der Steuereinheit gespeichert sind, belichtet und ausgehärtet, bis durch auf die aufeinanderfolgende Aushärtung von Schichten mit jeweils vorgegebener Kontur ein Formkörper mit der gewünschten Form hergestellt ist.

Die Belichtungseinheit weist zum Beispiel eine Lichtquelle auf, die Licht auf eine Abbildungseinheit richtet, die z.B. durch eine Matrix von Mikrospiegeln gebildet ist, die durch die Steuereinheit selektiv ansteuerbar sind, so dass jedes Bildelement im Belichtungsgebiet durch entsprechende Steuerung des zugehörigen Mikrospiegels selektiv belichtet werden kann. Sind alle Mikrospiegel eingeschaltet, wird das gesamte Belichtungsgebiet belichtet. Alternativ kann das Licht einer Lichtquelle auf eine sogenannte "Digital Light Valve", z.B. eine LCD-Matrix, gerichtet werden, wobei die einzelnen Bildelemente der LCD-Matrix individuell angesteuert werden, um für jedes Bildelement individuell den Durchgang von Licht zu gestatten oder zu blockieren. Durch intervallweises Öffnen und Schließen der einzelnen Bildelemente kann auch die Belichtungsintensität jedes Bildelements gesteuert werden, etwa durch Pulsbreitenmodulation.

Der Boden der Wanne zur Aufnahme des fließfähigen, photopolymerisierbaren Materials ist zumindest im Belichtungsgebiet transparent ausgebildet, z.B. durch eine Glasscheibe. Transparent im Sinne der vorliegenden Anmeldung bedeutet, dass der Wannenboden elektromagnetische Strahlung im für den Belichtungsvorgang relevanten Wellenlängenbereich zum Großteil passieren lässt; dabei kann aber durchaus eine gewisse Abschwächung der Intensität der elektromagnetischen Strahlung auftreten, soweit diese Abschwächung bei der Auswahl der Belichtungsintensität und Belichtungsdauer berücksichtigt wird, damit die Abschwächung kompensiert und eine möglichst vollständige Aushärtung der jeweils definierten Schicht aus photopolymerisierbaren Material bewirkt wird.

Die Definition der Schichtdicke durch Absenken der Bauplattform, so dass die Unterseite der zuletzt gebildeten Schicht in das nachgeführte photopolymerisierbare Material eintaucht, und Einstellen des Abstands der Unterseite der zuletzt gebildeten Schicht zum Wannenboden erlaubt eine sehr genaue Einstellung der Schichtdicke der nächsten auszuhärtenden Schicht. Typischerweise liegen Schichtdicken je nach Anwendung im Bereich von 10 µm bis 100 µm. Der Vorteil der genauen Einstellbarkeit der Schichtdicken überwiegt die Nachteile der damit einhergehenden Notwendigkeit, die Belichtungseinheit unter der Bauplattform unterhalb des Wannenbodens anordnen zu müssen.

In vielen Anwendungsfällen weisen die photopolymerisierbaren Materialien eine hohe Viskosität auf, was insbesondere der Fall ist, wenn mit Keramikpulver gefüllte photopolymerisierbare Materialien, sogenannte Schlicker, als Baumaterialien verwendet werden, was insbesondere bei der Herstellung von Dentalrestaurationen von Interesse ist. Eine erhöhte Viskosität der photopolymerisierbaren Materialien kann das Nachführen von Materialnachschub in das Belichtungsgebiet erschweren, da die Fließfähigkeit mit wachsender Viskosität des Materials abnimmt. Ferner kann auch das Absenken der Bauplattform mit den zuletzt daran gebildeten Schichten zur Definition der Schichtdicke der nächsten Schicht große Kraft erfordern, da überschüssiges photopolymerisierbares Material aus dem Zwischenraum verdrängt werden muss.

In diesem Zusammenhang ist es bekannt, dass die Fließfähigkeit von viskosen photopolymerisierbaren Materialien durch Erwärmen verbessert werden kann. In US 5,545,367 B1, die eine Stereolithographievorrichtung nach dem Oberbegriff von Anspruch 1 beschreibt, wird vorgeschlagen, die Wanne mit einer Heizeinrichtung zu versehen, um die Fließfähigkeit des in der Wanne befindlichen photopolymerisierbaren Materials zu verbessern. Dazu wird vorgeschlagen, die Wanne mit einer Heizeinrichtung zu ummanteln, Heizwendeln in das photopolymerisierbare Material eintauchen zu lassen, Infrarotlampen oder Mikrowellenstrahler auf das Material in der Wanne zu richten oder die Wanne insgesamt in einem Ofen zu platzieren.

Bei Stereolithographievorrichtungen wie der vorliegenden, bei der die Belichtung von unten durch einen transparenten Wannenboden erfolgt, besteht eine Schwierigkeit darin, dass die Heizeinrichtung die Belichtung im Belichtungsgebiet nicht stören darf, d.h. die Heizeinrichtung kann eigentlich nur außerhalb des Belichtungsgebietes auf das photopolymerisierbare Material einwirken, da im Belichtungsgebiet unter der Bauplattform sonst die Belichtung gestört würde. Eine indirekte Aufheizung, die durch Wärmeleitung und Transport des erwärmten Materials in das Belichtungsgebiet erfolgt, ist aber wenig effektiv und erlaubt keine definiert einstellbare Temperatur des photopolymerisierbaren Materials im Belichtungsgebiet.

Es ist Aufgabe der vorliegenden Erfindung, eineStereolithographievorrichtung mit Belichtung durch den Wannenboden und mit einer Heizeinrichtung so auszubilden, dass eine effektive und gleichmäßige Erwärmung desphotopolymerisierbaren Materials im Belichtungsgebiet möglich ist.

Zur Lösung dieser Aufgabe dient die Stereolithographievorrichtung mit den Merkmalen des Patentanspruchs 1. Vorteilhafte Ausführungsformen der Erfindung sind in den Unteransprüchen angegeben.

Erfindungsgemäß ist vorgesehen, dass die Heizeinrichtung eine über dem Wannenboden angeordnete, wenigstens das Belichtungsgebiet vollflächig abdeckende, elektrisch leitfähige und transparente Schicht aufweist, die außerhalb des Belichtungsgebiets an gegenüberliegenden Seiten der Schicht mit über die gegenüberliegenden Seiten ausgedehnten elektrischen Kontaktierungen versehen ist. Die elektrischen Kontaktierungen sind mit einem gesteuerten elektrischen Versorger verbunden, so dass durch Stromfluss durch die gesamte Schicht eine vollflächige Beheizung des photopolymerisierbaren Materials im Belichtungsgebiet möglich ist. Die elektrisch leitfähige transparente Schicht weist vorzugsweise eine homogene Schichtdicke auf, um eine homogene Verteilung der Heizleistung zu gewährleisten.

Durch die vollflächige Beheizung des photopolymerisierbaren Materials im Belichtungsgebiet, wo durch die Heizeinrichtung auf das Material der als nächstes auszubildende Schicht eingewirkt wird, wird eine sehr effektive Erwärmung des photopolymerisierbaren Materials genau in dem Gebiet, wo die Verarbeitung des Materials stattfindet, erreicht, ohne dass dabei die Belichtung gestört wird. Die Transparenz der leitfähigen Schicht bedeutet hier, wie beim Wannenboden, wiederum nicht zwangsläufig, dass überhaupt keine Abschwächung der zur Belichtung verwendeten elektromagnetischen Strahlung in der Schicht stattfindet. Eine gewisse Abschwächung kann durchaus gegeben sein, soweit diese bei der Einstellung von Belichtungsintensität und Belichtungsdauer berücksichtigt wird. Grundsätzlich kann die Transparenz sogar als Funktion des Ortes im Belichtungsgebiet variieren, wobei das dann durch eine ortsabhängige Einstellung der Intensität der Belichtung kompensierend berücksichtigt werden muss.

Die elektrische Kontaktierung erfolgt an zwei gegenüberliegenden Randseiten durch gegenüberliegende, diese Randseiten überdeckende Kontakte. Es können zwei gegenüberliegende Randstreifen einer von oben gesehen zum Beispiel quadratischen oder rechteckigen Schicht durch jeweils einen dünnen Leiterstreifen aus Kupfer bedeckt sein, zu denen jeweils eine elektrische Leitung eines Stromkreises führt, in dem auch ein elektrischer Versorger vorgesehen ist. Die dünnen gegenüberliegenden Kupferstreifen können daher an den gegenüberliegenden Randbereichen direkt und flächig auf der elektrisch leitfähigen Schicht aufliegen, um diese auf ganzer Breite homogen mit elektrischer Energie zu versorgen.

Insbesondere wird durch die Erwärmung des photopolymerisierbaren Materials im Belichtungsgebiet und die damit einhergehende Verringerung der Viskosität des Materials erreicht, dass die Bauplattform mit der Unterseite der zuletzt daran gebildeten Schicht in das Material abgesenkt werden kann, um die gewünschte Schichtdicke des photopolymerisierbaren Materials definieren zu können, ohne dass die dabei auftretende Verdrängung von Material aus dem Zwischenraum zwischen der Unterseite der zuletzt gewählten Schicht und dem Wannenboden zu große Kraft erfordern würde. Dadurch kann die vorteilhafte Schichtdickendefinition durch Absenken der Bauplattform zum photopolymerisierbaren Material hin auch bei viskosen Materialien durchgeführt werden, ohne dass zu große und schwer handhabbare Kräfte auf die Bauplattform und die daran bereits gebildeten Schichten ausgeübt werden müssten, umbei der Schichtdefinition durch Absenken Material aus dem Zwischenraum zu verdrängen.

In einer bevorzugten Ausführungsform ist die elektrisch leitfähige transparente Schicht auf einer transparenten Kunststofffolie als Trägerfolie aufgebracht, die wiederum über dem Wannenboden angeordnet ist. Dabei kann die Kunststoffträgerfolie mit der elektrisch leitfähigen Schicht so angeordnet sein, dass die Kunststoffträgerfolie dem Wannenboden zugewandt und die elektrische Schicht von diesem abgewandt ist oder umgekehrt die transparente Kunststoffträgerfolie oberhalb der elektrisch leitfähigen Schicht liegt, die dann dem Wannenboden zugewandt ist.

In einer alternativen Ausführungsformen übernimmt eine Kunststoffträgerfolie die Funktion des Wannenbodens, d.h. die Wanne ist im Belichtungsbereich unten offen und diese Öffnung wird von einer den Wannenboden bildende Kunststoffträgerfolie abgeschlossen, die wiederum elektrisch leitfähige Schicht und eventuell weitere Schichten wie eine Silikonschicht und oben eine Kunststoffschutzfolie trägt.

Die elektrisch leitfähige transparente Schicht kann in einem Verbund von mehreren Schichten über dem Wannenboden angeordnet sein. Über dem Wannenboden kann zum Beispiel zunächst eine transparente Silikonschicht aufgebracht sein, über der die elektrisch leitfähige Schicht liegt, die wiederum von einer transparenten Kunststoffschutzfolie abgedeckt wird.

Alternativ kann über dem Wannenboden zunächst die elektrisch leitfähige Schicht liegen, über der dann eine transparente Silikonschicht liegt, die wiederum von einer darüber angeordneten Kunststoffschutzfolie abgedeckt ist. Auch in diesen Fällen kann die elektrisch leitfähige Schicht auf eine transparente Kunststoffträgerfolie aufgebracht sein und in dieser Form in den genannten Schichtverbundanordnungen liegen.

In beiden Fällen dient die Silikonschicht dazu, um auf die Schichtfolge einwirkende Spannungen aufzunehmen, die beim Anheben der Bauplattform mit der zuletzt daran ausgehärteten Schicht auftreten können, wenn die Unterseite der zuletzt ausgebildeten Schicht im gewissen Umfang an der obersten Schicht auf dem Wannenboden anhaftet. Bei Kräften auf die Schichtfolge auf dem Wannenboden, die beim Abziehen der zuletzt gebildeten Schicht durch die Hebeeinrichtung nach oben auftreten können, kann die Silikonschicht sich in gewissem Umfang elastisch verformen und so eine gewisse elastische Verformung der Schichtfolge am Wannenboden zulassen, was Spannungen in der Schichtfolge am Wannenboden reduziert.
In einer bevorzugten Ausführungsform ist an der elektrisch leitfähigen Beschichtung in Wärmeleitungskontakt mit dieser ein Temperatursensor angeordnet. Der Temperatursensor ist mit einer Steuerung verbunden, die dazu eingerichtet ist, auf den elektrischen Versorger einzuwirken und den Stromfluss durch die elektrisch leitfähige Beschichtung so zu regeln, dass eine gewünschte eingegebene Temperatur oder ein gewünschter zeitlicher Temperaturverlauf im Bereich der elektrisch leitfähigen Schicht über dem Wannenboden bewirkt wird. Der Temperatursensor liegt dabei vorzugsweise am äußeren Rand des Belichtungsgebiets oder außerhalb von diesen, so dass der Temperatursensor und die zugehörigen Leitungsverbindungen den Belichtungsvorgang nicht stören. Die Steuerung kann zum Beispiel ein PI-Regler (Proportional Integral Controller) oder ein PID-Regler (Proportional Integral Derivative Controller) sein.

Als Materialien für eine Kunststoffträgerfolie für die elektrisch leitfähige Schicht kommen alle transparenten Kunststoffe in Betracht, also zum Beispiel Polyethylen (PP), Polypropylen (PP), Polytetrafluorethylen (PTFE) oder Polyfluorethylenpropylen(FEP - ein Copolymerisat auf Basis von Tetrafluorethylen und Hexafluorpropylen).

Für die Kunststoffschutzfolie zur Abdeckung der Schichtfolge am Wannenboden stellt sich neben der Transparenz die zusätzliche Anforderung, dass das polymerisierte Baumaterial nach Aushärtung möglichst wenig an der Kunststoffschutzfolie anhaften sollte. In dieser Hinsicht sind insbesondere die schon genannten Kunststoffe Polytetrafluorethylen (PTFE) und Polyfluorethylenpropylen (FEP) geeignet.

In einer bevorzugten Ausführungsform weist das Material der elektrisch leitfähigen Schicht Indiumzinnoxid (ITO), mit Fluor dotiertes Zinnoxid (SnO2:F), mit Aluminium dotiertes Zinnoxid (Zn02:Al), Aluminiumzinkoxid (AZO), mit Antimon dotiertes Zinnoxid (SnO2:Sb), Graphen oder andere elektrisch leitende Kohlenstoffverbindungen oder elektrisch leitfähige Polymere oder andere geeignete metallische Materialien auf.

Vorzugsweise ist die elektrisch leitfähige transparente Schicht so ausgebildet, dass sie einen Flächenwiderstand bildet und dieser im Bereich von 1-1000 Ω/□ liegt.

Der Flächenwiderstand beschreibt den elektrischen Widerstand einer elektrisch leitfähigen Schicht einer so geringen Dicke, dass diese lediglich parallel zur Schicht von elektrischem Strom durchflossen wird, d.h. der Strom tritt an einer Randseite ein und an der gegenüberliegenden Randseite wieder aus. Der Flächenwiderstand einer Schicht der Dicke d mit einem isotropenspezifischen Widerstand p beträgt p/d. D.h. je dünner die Schicht, desto höher ist ihr Flächenwiderstand(bei konstantem spezifischen Widerstand ρ). Der Flächenwiderstand hat also die gleiche Einheit Ω wie ein Ohmscher Widerstand. Um eine Größe als Flächenwiderstand zu kennzeichnen, wird aber zur Verdeutlichung ein Symbol hinzugefügt, das "pro quadratischer Fläche" andeuten soll, nämlich /□. Im Englischen wird auch die Einheitenabkürzung Ω/sq verwendet, wobei "sq" als Kürzel für "square" steht.

Im Zusammenhang mit der vorliegenden Erfindung können Schichten mit einer Dicke von etwa 1 nm bis einige 100 nm verwendet werden. Zum Beispiel kann eine Indiumzinnoxid-Schicht beschichtete Folie (mit einer Dicke der Indiumzinnoxid-Schicht von 100 nm) verwendet werden, die einen Flächenwiderstand von 50 Ω/□ hat. Diese kann mit einer typischen Leistungsdichte von bis zu 750 W/m² betrieben werden. Bei Versuchen unter Laborbedingungen ließen sich damit Temperaturen von 40°C bis 100°C in dem photopolymerisierbaren Material im Belichtungsgebiet realisieren.

Die elektrisch leitfähige, transparente Schicht soll mindestens das Belichtungsgebiet abdecken, um dort für eine erhöhte Temperatur sorgen zu können. Vorzugsweise kann die elektrisch leitfähige, transparente Schicht aber auch über das Belichtungsgebiet hinausreichen, insbesondere im Wesentlichen den ganzen Wannenboden abdecken. Dadurch kann auch das Material außerhalb des Belichtungsgebietes bereits erwärmt werden, so dass das Nachführen von photopolymerisierbarem Material von dort in das Belichtungsgebiet nach dem Anheben der Bauplattform leichter durchführbar ist.

Die Erfindung wird im Folgenden anhand von Ausführungsbeispielen im Zusammenhang mit den Zeichnungen beschrieben, in denen:
Fig. 1 eine schematische Darstellung von Komponenten einer erfindungsgemäßen Stereolithographievorrichtung zeigt,
Fig. 2 eine Querschnittsansicht durch einen Wannenboden einer Stereolithographievorrichtung nach einer ersten Ausführungsform zusammen mit einer vergrößerten Detailansicht zeigt,
Fig. 3 eine Querschnittsansicht durch einen Wannenboden einer Stereolithographievorrichtung nach einer zweiten Ausführungsform zusammen mit einer vergrößerten Detailansicht zeigt,
Fig. 4 eine Querschnittsansicht durch einen Wannenboden einer Stereolithographievorrichtung nach einem dritten Ausführungsbeispiel zusammen mit einer vergrößerten Detailansicht zeigt,
Fig. 5 eine Explosionsdarstellung des Wannenbodens aus Fig. 3 zeigt.

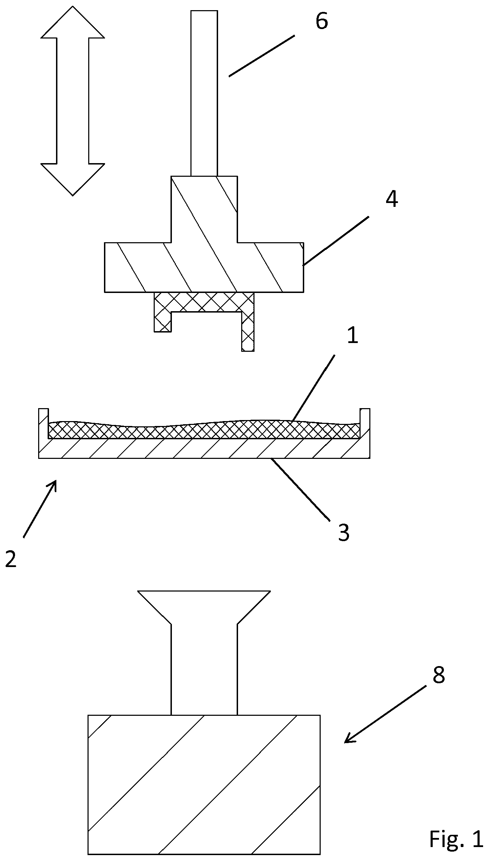

Fig. 1 zeigt schematisch einzelne Komponenten einer Stereolithographievorrichtung (allerdings ohne Träger und Gehäuseteile). Die Stereolithographievorrichtung weist eine Wanne 2 mit transparentem Wannenboden 3 auf, in die fließfähiges photopolymerisierbares Material 1 eingefüllt ist. In dem photopolymerisierbaren Material 1 wird (beim Aufbau der ersten Schicht an einer Bauplattform 4), diese Bauplattform 4 in das photopolymerisierbare Material 1 hinein soweit abgesenkt, dass die Unterseite der Bauplattform 4 in einem vorgegebenen Abstand zum Wannenboden liegt, so dass gerade die gewünschte Schichtdicke von photopolymerisierbaren Material zwischen der Bauplattform und dem Wannenboden verbleibt. Nach Aushärten der ersten Schicht an der Bauplattform 4 wird diese angehoben, photopolymerisierbares Material von außen in das Belichtungsgebiet nachgeführt (soweit das photopolymerisierbare Material nicht hinreichend flüssig ist, um von selbst in das Belichtungsgebiet nachzufließen, kann eine relativ zum Wannenboden bewegbare Rakel verwendet werden, um photopolymerisierbares Material in das Belichtungsgebiet zu schieben). Anschließend wird die Bauplattform 4 mit der daran bereits gebildeten Schicht soweit in das photopolymerisierbare Material 1 abgesenkt bis die Unterseite der zuletzt gebildeten Schicht den Abstand zum Wannenboden hat, der gleich der gewünschten Schichtdicke für die als nächstes auszuhärtende Schicht aus photopolymerisierenden Materials ist. Diese Schritte werden sukzessive unter Bildung von aufeinanderfolgenden Schichten mit jeweils vorgegebener Kontur wiederholt, bis die Abfolge der Schichten den gewünschten Formkörper ergibt.

Zum gesteuerten Anheben und Absenken der Bauplattform 4 ist diese an einer steuerbaren Hebeeinrichtung 6 aufgehängt.

Unterhalb der Wanne 2 ist eine Belichtungseinheit 8 angeordnet, die von unten auf ein Belichtungsgebiet an dem Wannenboden 3 gerichtet ist. Die Belichtungseinheit 8 ist dazu ausgebildet, um unter Steuerung einer Steuereinheit ein gewünschtes Muster von individuell angesteuerten Bildelementen in dem Belichtungsgebiet zu erzeugen, wobei sich aus den belichteten Bildelementen die Form der auszuhärtenden Schicht ergibt. Die Belichtungseinheit 8 kann zum Beispiel eine Lichtquelle und ein Feld mit einer größeren Anzahl von Mikrospiegeln aufweisen, die von einer Steuereinheit individuell verschwenkbar sind, um das zugehörige Bildelement im Belichtungsgebiet entweder zu belichten oder nicht zu belichten. Darüber hinaus kann auch die Intensität der belichteten Bildelemente durch Ein- und Ausschalten der individuellen Mikrospiegel in gewünschter Weise ortsabhängig gesteuert werden.

Der Wannenboden 3 ist zumindest im Belichtungsgebiet transparent ausgebildet, z.B. durch eine dünne Glasscheibe. Der Begriff transparent für den Wannenboden und für die später noch näher zu beschreibende elektrisch leitfähige Schicht bedeutet dass diese in gewissem Grad lichtdurchlässig sind, es muss keine nahezu vollständige Lichtdurchlässigkeit gegeben sein. Eine etwaige Abschwächung der für die Belichtung benutzten elektromagnetischen Wellen in dem Material des Wannenbodens oder der elektrisch leitfähigen Schicht kann durch entsprechende Erhöhung der Belichtungsintensität oder der Belichtungsdauer vorab berücksichtigt werden.

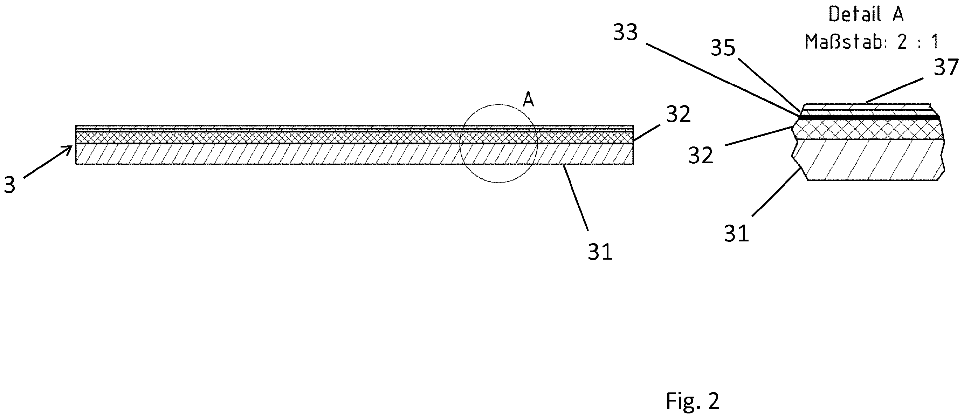

Fig. 2 zeigt eine schematische Querschnittsansicht durch einen Wannenboden 3 und eine darauf aufgebrachte Heizeinrichtung im Belichtungsgebiet sowie eine vergrößerte Detailansicht aus dem Querschnitt. Der Wannenboden weist eine Glasplatte 31 auf, auf die eine transparente Silikonschicht 32 aufgebracht ist. Auf die Silikonschicht 32 ist eine Kunststoffträgerfolie 35 aufgelegt, die an ihrer Unterseite eine elektrisch leitfähige, transparente Beschichtung 33 aufweist. Bei der Kunststoffträgerfolie 35 kann es sich zum Beispiel um eine Folie ausPolypropylen, Polytetrafluorethylen, Polyfluorethylenpropylen oder Polyethylen handeln. Die elektrisch leitfähige transparente Beschichtung kann z.B. aus Indiumzinnoxid bestehen. Auf die transparente Kunststoffträgerfolie 35 ist wiederum eine transparente Kunststoffschutzfolie 37 aufgebracht. Auf eine solche transparente Kunststoffschutzfolie 37 kann in dem vorliegenden Ausführungsbeispiel aber auch deswegen verzichtet werden, da die elektrisch leitfähige, transparente Schicht 33 bereits durch ihre Kunststoffträgerfolie 35 abgedeckt und geschützt ist.

Es ist zu beachten, dass die Querschnittansichten wie in Fig. 2 nur schematisch und nicht maßstabsgerecht sind, d.h. die relativen Schichtdicken sollen dadurch nicht realistisch gezeigt sein. Ferner ist die transparente, elektrisch leitfähige Schicht 33, die relativ dünn dargestellt ist, aus Darstellungsgründen durch eine schwarze Linie wiedergegeben, was sie aber nur besser sichtbar machen soll und rein symbolisch gemeint ist. Tatsächlich sollen sämtliche Schichten in dem Schichtenverbund transparent sein.

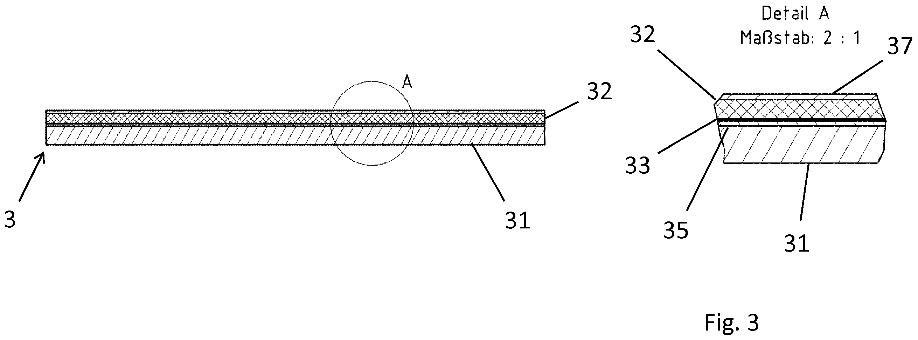

Fig. 3 zeigt einen Fig. 2 entsprechenden Querschnitt eines zweiten Ausführungsbeispiels, das sich von dem aus Fig. 2 dadurch unterscheidet, dass die transparente Silikonschicht 32 und die transparente Kunststoffträgerfolie 35 mit der elektrisch leitfähigen, transparenten Schicht 33 an ihrer Unterseite ihre Positionen vertauscht haben, d.h. die Kunststoffträgerfolie 35 liegt mit der elektrisch leitfähigen, transparenten Schicht 33 direkt auf dem transparenten Wannenboden 31 auf.

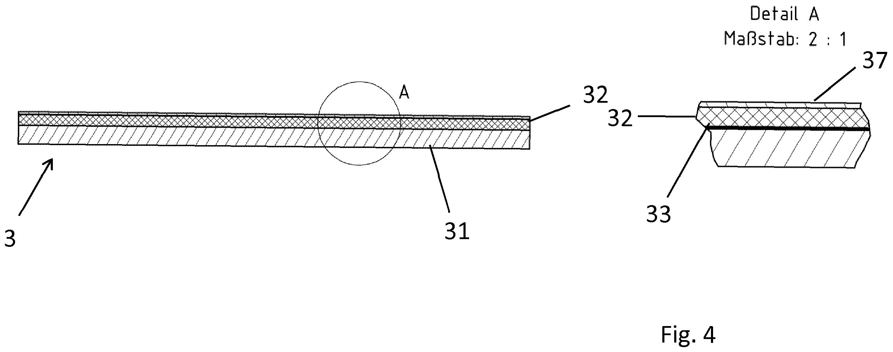

Fig. 4 zeigt eine den beiden vorherigen Ausführungsbeispielen in den Figuren 1 und 2 entsprechende Querschnittsansicht eines dritten Ausführungsbeispiels, das sich von dem zweiten Ausführungsbeispiel in Fig. 3 dadurch unterscheidet, dass die elektrisch leitfähige transparente Schicht 33 nicht wie in Fig. 3 auf einer Kunststoffträgerfolie 35 aufgebracht ist, sondern die elektrisch leitfähige, transparente Schicht 33 direkt auf die transparente Glasplatte 31 aufgebracht ist, und auf die elektrisch leitfähige, transparente Schicht 33 direkt die transparente Silikonschicht 32 und darauf die transparente Kunststoffschutzfolie 37 folgt.

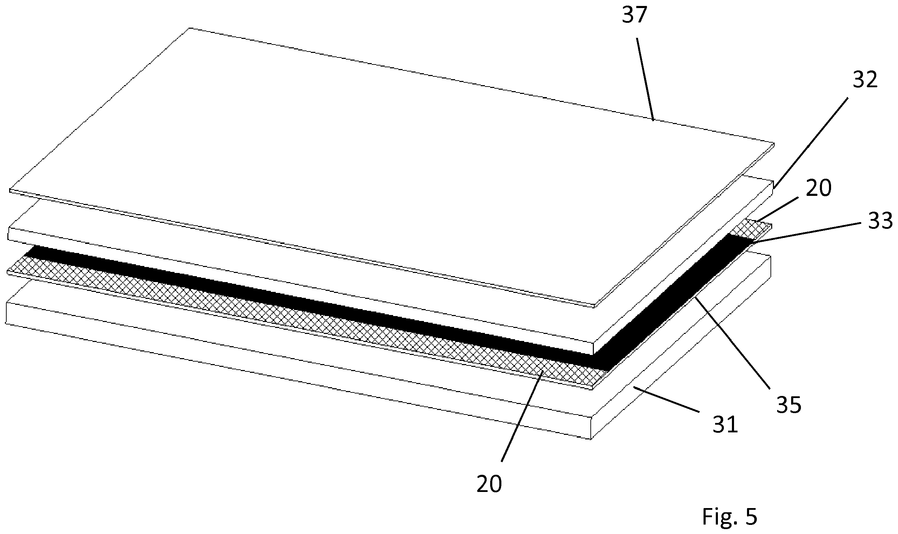

Fig. 5 zeigt den Aufbau des Wannenbodens mit Heizeinrichtung des zweiten Ausführungsbeispiels in einer Explosionsdarstellung, d.h. der transparente Wannenboden und die darauf folgenden Schichten sind voneinander abgehoben. In Fig. 5 ist die elektrische Kontaktierung der elektrisch leitfähigen, transparenten Schicht 33 dargestellt. Diese erfolgt durch zwei gegenüberliegende Streifen 20 eines dünnen metallischen Leiters, wobei diese bandförmigen metallischen Leiterstreifen direkt auf den gegenüberliegenden Randstreifen der elektrisch leitfähigen, transparenten Schicht 33 aufliegen. Jeder der beiden Metallstreifen 20 ist mit einer elektrischen Leitung verbunden, die zusammen mit einem elektrischen Versorger mit Regler (nicht dargestellt) einen Stromkreis bilden, um durch geregelten Stromfluss durch die elektrisch leitfähige, transparente Schicht 33 eine gewünschte Heizleistung zu erzeugen.

Zur Regelung der durch den elektrischen Versorger zuzuführenden elektrischen Leistung kann an der elektrisch leitfähigen, transparenten Schicht 33 ein Temperatursensor in Wärmeleitungskontakt mit der elektrisch leitfähigen, transparenten Schicht 33 angeordnet sein, um deren Temperatur zu erfassen. Der Temperatursensor ist mit einem Regler versehen, der wiederum mit dem steuerbaren elektrische Versorger verbunden ist, um dessen Leistung zu regeln, so dass eine gewünschte Temperatur an der elektrisch leitfähigen, transparenten Schicht 33 eingestellt wird.

## Patentansprüche

1. Stereolithographievorrichtung mit einer Wanne (2) zur Aufnahme von fließfähigem, photopolymerisierbarem Material, die wenigstens in einem für Belichtungen vorgesehenen Belichtungsgebiet einen transparenten Wannenboden (3) aufweist, einer unter der Wanne angeordneten Belichtungseinheit (8) zur Belichtung einer Fläche mit einer für die jeweils zu bildende Schicht vorgegebenen Kontur innerhalb des Belichtungsgebiets, einer über dem Wannenboden an einer Hebeeinrichtung (6) aufgehängten Bauplattform (4), an der anhängend die erste durch Belichtung ausgehärtete Schicht zu bilden ist, einer Steuereinheit, die dazu eingerichtet ist, sukzessive Belichtungen mit jeweils vorgegebener Kontur durch die Belichtungseinheit zu bewirken und die Stellung der Bauplattform über dem Wannenboden sukzessive jeweils nach dem Belichten einer weiteren Schicht anzupassen, und mit einer Heizeinrichtung zur Erwärmung des photopolymerisierbaren Materials in der Wanne, **dadurch gekennzeichnet, dass** die Heizeinrichtung eine über dem Wannenboden eine wenigstens das Belichtungsgebiet vollflächig überdeckende transparente, elektrisch leitfähige Schicht (33) aufweist, die außerhalb des Belichtungsgebiets an gegenüberliegenden Seiten der Schicht mit über die gegenüberliegenden Seiten ausgedehnten elektrischen Kontaktierungen (20) versehen ist, die mit einem gesteuerten elektrischen Versorger verbunden sind, um durch Stromfluss durch die Schicht eine vollflächige Beheizung von photopolymerisierbarem Material über dem Wannenboden im Belichtungsgebiet zu ermöglichen.

2. Stereolithographievorrichtung nach Anspruch 1, **dadurch gekennzeichnet, dass** die elektrisch leitfähige Beschichtung(33) auf einer transparenten Kunststofffolie als Trägerfolie (35) aufgebracht ist, die wiederum über dem Wannenboden angeordnet ist.

3. Stereolithographievorrichtung nach Anspruch 1, **dadurch gekennzeichnet, dass** der Wannenboden im Belichtungsgebiet durch eine transparente Kunststoffträgerfolie gebildet wird, über der die elektrisch leitfähige Schicht liegt.

4. Stereolithographievorrichtung nach Anspruch 1 oder 2, **dadurch gekennzeichnet, dass** über dem Wannenboden (3) zunächst eine transparente Silikonschicht (32), darüber die elektrisch leitfähige Schicht (33) und darüber zur Abdeckung der elektrisch leitfähigen Beschichtung eine transparente Kunststoffschutzfolie (37) angebracht ist.

5. Stereolithographievorrichtung nach Anspruch 1 oder 2, **dadurch gekennzeichnet, dass** über dem Wannenboden (3) die elektrisch leitfähige Schicht (33) liegt, über der eine transparente Silikonschicht (32) angeordnet ist, welche schließlich von einer darüber zur Abdeckung angeordneten Kunststoffschutzfolie (37) überdeckt ist.

6. Stereolithographievorrichtung nach einem der vorhergehenden Ansprüche, **dadurch gekennzeichnet, dass** an der elektrisch leitfähigen Schicht (33) in Wärmeleitungskontakt mit dieser ein Temperatursensor angeordnet ist, der mit einer Steuerung verbunden ist, die dazu eingerichtet ist, den Stromfluss durch die elektrische leitfähige Beschichtung so zu regeln, dass eine gewünschte Temperatur oder ein gewünschter zeitlicher Temperaturverlauf in Bereich der elektrisch leitfähigen Beschichtung über dem Wannenboden bewirkt wird.

7. Stereolithographievorrichtung nach Anspruch 2 oder 3, **dadurch gekennzeichnet, dass** als Kunststoffträgerfolien (35) für die elektrisch leitfähige Beschichtung Folien aus Polyethylen (PE), Polypropylen (PP), Polytetrafluorethylen (PTFE)oder Polyfluorethylenpropylen (FEP) sind.

8. Stereolithographievorrichtung nach Anspruch 4 oder 5, **dadurch gekennzeichnet, dass** die Kunststoffschutzfolien (37) Folien aus Polytetrafluorethylen (PTFE) oder Polyfluorethylenpropylen (FEP) sind.

9. Stereolithographievorrichtung nach einem der vorhergehenden Ansprüche, **dadurch gekennzeichnet, dass** das Material der elektrisch leitfähigen Schicht Indiumzinnoxid (ITO) mit Fluor dotiertes Zinnoxid (SnO2:F), mit Aluminium dotiertes Zinnoxid (ZnO2:Al), Aluminiumzinkoxid (AZO), mit Antimon dotiertes Zinnoxid (SnO2:Sb), Graphen oder andere elektrisch leitende Kohlenstoffverbindungen, elektrisch leitfähige Polymere oder geeignete metallische Verbindungen aufweist.

10. Stereolithographievorrichtung nach einem der vorhergehenden Ansprüche, **dadurch gekennzeichnet, dass** die elektrisch leitfähige transparente Beschichtung so ausgebildet ist, dass sie einen Flächenwiderstand im Bereich von 1-1000 Ω/□ aufweist.

11. Stereolithographievorrichtung nach einem der vorhergehenden Ansprüche, **dadurch gekennzeichnet, dass** auf dem Wannenboden auch im Bereich außerhalb des Belichtungsgebietes elektrische Heizeinrichtungen vorhanden sind.

12. Stereolithographievorrichtung nach Anspruch 11, **dadurch gekennzeichnet, dass** die elektrisch leitfähige transparente Schicht (33) sich über das Belichtungsgebiet hinaus über den Wannenboden (3) erstreckt.

## Claims

1. A stereolithography device having a trough (2) for accommodating free-flowing, photopolymerizable material, which has a transparent trough bottom (3) at least in an exposure region provided for exposures, an exposure unit (8), which is arranged below the trough, for exposing a surface having a predefined contour for the layer to be formed in each case inside the exposure region, a construction platform (4) suspended above the trough bottom on a lifting unit (6), on which the first layer cured by exposure is to be formed suspended thereon, a control unit, which is configured to cause successive exposures each having predefined contour by way of the exposure unit and to adapt the position of the construction platform above the trough bottom successively in each case after the exposure of a further layer, and having a heating unit for heating the photopolymerizable material in the trough, **characterized in that** the heating unit has a transparent, electrically conductive layer (33), which covers the entire area of at least the exposure region above the trough bottom, and which is provided outside the exposure region on opposing sides of the layer with electrical contacts (20) extended over the opposing sides, which are connected to a controlled electrical supplier to enable heating of the entire area of photopolymerizable material above the trough bottom in the exposure region by current flow through the layer.

2. The stereolithography device according to Claim 1, **characterized in that** the electrically conductive coating (33) is applied to a transparent plastic film as a carrier film (35), which is in turn arranged above the trough bottom.

3. The stereolithography device according to Claim 1, **characterized in that** the trough bottom is formed in the exposure region by a transparent plastic carrier film, above which the electrically conductive layer lies.

4. The stereolithography device according to Claim 1 or 2, **characterized in that** firstly a transparent silicone layer (32) is applied above the trough bottom (3), the electrically conductive layer (33) is applied above this, and a transparent plastic protective film (37) is applied above this to cover the electrically conductive coating.

5. The stereolithography device according to Claim 1 or 2, **characterized in that** the electrically conductive layer (33) lies above the trough bottom (3), above which a transparent silicone layer (32) is arranged, which is finally covered by a plastic protective film (37) arranged above it for the cover.

6. The stereolithography device according to any one of the preceding claims, **characterized in that** a temperature sensor is arranged on the electrically conductive layer (33) in heat conductive contact therewith, this sensor being connected to a controller, which is configured to control the current flow through the electrically conductive coating so that a desired temperature or a desired chronological temperature curve is caused in the region of the electrically conductive coating above the trough bottom.

7. The stereolithography device according to Claim 2 or Claim 3, **characterized in that** films made of polyethylene (PE), polypropylene (PP), polytetrafluoroethylene (PTFE), or polyfluoroethylene propylene (FEP) are plastic carrier films (35) for the electrically conductive coating.

8. The stereolithography device according to Claim 4 or 5, **characterized in that** the plastic protective films (37) are films made of polytetrafluoroethylene (PTFE) or polyfluoroethylene propylene (FEP).

9. The stereolithography device according to any one of the preceding claims, **characterized in that** the material of the electrically conductive layer has indium tin oxide (ITO), tin oxide doped with fluorine (SnO2:F), tin oxide doped with aluminum (ZnO2:Al), aluminum zinc oxide (AZO), tin oxide doped with antimony (SnO2:Sb), graphene or other electrically conductive carbon compounds, electrically conductive polymers, or suitable metallic compounds.

10. The stereolithography device according to any one of the preceding claims, **characterized in that** the electrically conductive transparent coating is implemented so that it has a sheet resistance in the range of 1-1000 Ω/□.

11. The stereolithography device according to one of the preceding claims, **characterized in that** electrical heating units are also provided on the trough bottom in the region outside the exposure region.

12. The stereolithography device according to Claim 11, **characterized in that** the electrically conductive transparent layer (33) extends beyond the exposure region above the trough bottom (3).

## Revendications

1. Dispositif de stéréo-lithographie avec une cuve (2) pour la réception de matériau photopolymérisable, coulant laquelle présente au moins un fond de cuve (3) transparent dans une zone d'exposition prévue pour des expositions, avec une unité d'exposition (8) agencée sous la cuve pour l'exposition d'une surface avec un contour prédéfini pour la couche à former respectivement à l'intérieur de la zone d'exposition, avec une plateforme de construction (4) suspendue à un dispositif de levage (6) au-dessus du fond de cuve, accrochée à laquelle la première couche durcie par exposition doit être formée, avec une unité de commande, qui est conçue pour induire des expositions successives avec le contour respectivement prédéfini par l'unité d'exposition et adapter la position de la plateforme de construction au-dessus du fond de cuve peu à peu respectivement après l'exposition d'une autre couche, et avec un dispositif de chauffage pour le réchauffage du matériau photopolymérisable dans la cuve, **caractérisé en ce que** le dispositif de chauffage présente une couche (33) électriquement conductrice, transparente recouvrant au moins toute la surface de la zone d'exposition au-dessus du fond de cuve qui est dotée, à l'extérieur de la zone d'exposition au niveau de côtés opposés de la couche, de contacts électriques (20) s'étendant au-dessus des côtés opposés, qui sont reliés à une alimentation électrique commandée pour permettre un chauffage de toute la surface de matériau photopolymérisable au-dessus du fond de cuve dans la zone d'exposition par flux de courant à travers la couche.

2. Dispositif de stéréo-lithographie selon la revendication 1, **caractérisé en ce que** le revêtement (33) électriquement conducteur est appliqué sur un film plastique transparent sous forme de film de support (35), qui est agencé à son tour au-dessus du fond de cuve.

3. Dispositif de stéréo-lithographie selon la revendication 1, **caractérisé en ce que** le fond de cuve est formé dans la zone d'exposition par un film de support plastique transparent, au-dessus duquel se trouve la couche électriquement conductrice.

4. Dispositif de stéréo-lithographie selon la revendication 1 ou 2, **caractérisé en ce qu'**au-dessus du fond de cuve (3), une couche de silicone transparente (32) est d'abord placée, au-dessus la couche électriquement conductrice (33) et au-dessus un film de protection plastique (37) transparent pour recouvrir le revêtement électriquement conducteur.

5. Dispositif de stéréo-lithographie selon la revendication 1 ou 2, **caractérisé en ce qu'**au-dessus du fond de cuve (3) se trouve la couche électriquement conductrice (33), au-dessus de laquelle une couche de silicone transparente (32) est disposée, laquelle est finalement recouverte d'un film de protection plastique (37) disposé au-dessus pour la recouvrir.

6. Dispositif de stéréo-lithographie selon l'une quelconque des revendications précédentes, **caractérisé en ce qu'**un capteur de température est agencé au niveau de la couche électriquement conductrice (33) en contact de conduction de chaleur avec celle-ci, lequel est relié à la commande, qui est conçu pour réguler le flux de courant à travers le revêtement électriquement conducteur de façon à ce qu'une température souhaitée ou une courbe de température en fonction du temps souhaitée soit induite au niveau du revêtement électriquement conducteur au-dessus du fond de cuve.

7. Dispositif de stéréo-lithographie selon la revendication 2 ou 3, **caractérisé en ce que** des films en polyéthylène (PE), polypropylène (PP), polytétrafluoroéthylène (PTFE) ou éthylène propylène fluoré (FEP) sont utilisés comme films de support plastique (35) pour le revêtement électriquement conducteur.

8. Dispositif de stéréo-lithographie selon la revendication 4 ou 5, **caractérisé en ce que** les films de protection plastique (37) sont des films en
polytétrafluoroéthylène (PTFE) ou en éthylène propylène fluoré (FEP).

9. Dispositif de stéréo-lithographie selon l'une quelconque des revendications précédentes, **caractérisé en ce que** le matériau de la couche électriquement conductrice présente de l'oxyde d'indium-étain (ITO), de l'oxyde d'étain dopé au fluor (SnO2:F), de l'oxyde d'étain dopé à l' aluminium (ZnO2:Al), de l'oxyde d'aluminium-zinc (AZO), de l'oxyde d'étain dopé à l'antimoine (SnO2:Sb), du graphène ou d'autres liaisons au carbone électriquement conductrices, des polymères électriquement conducteurs ou des liaisons métalliques adaptées.

10. Dispositif de stéréo-lithographie selon l'une quelconque des revendications précédentes, **caractérisé en ce que** le revêtement transparent électriquement conducteur est réalisé de façon à présenter une résistance surfacique de l'ordre de 1-1000 Ω/□.

11. Dispositif de stéréo-lithographie selon l'une quelconque des revendications précédentes, caractérisé en que des dispositifs de chauffage électriques sont présents sur le fond de cuve aussi dans la zone à l'extérieur de la zone d'exposition.

12. Dispositif de stéréo-lithographie selon la revendication 11, caractérisé en que la couche transparente électriquement conductrice (33) s'étend au-delà de la zone d'exposition au-dessus du fond de cuve (3).
